# EUROPEAN PATENT SPECIFICATION

(11) **EP 4 485 522 B1**
(45) Date of publication and mention of the grant of the patent: **15.10.2025**
(21) Application number: 23182782.5
(22) Date of filing: 30.06.2023
(51) Int. Cl.: H01L 23/00

(54) **POWER SEMICONDUCTOR MODULE COMPRISING EMBEDDED FLEXIBLE ELECTRICAL SIGNAL CONNECTOR AND METHOD FOR PRODUCING A POWER SEMICONDUCTOR MODULE**
LEISTUNGSHALBLEITERMODUL MIT EINGEBETTETEM FLEXIBLEM ELEKTRISCHEN SIGNALVERBINDER UND VERFAHREN ZUR HERSTELLUNG EINES LEISTUNGSHALBLEITERMODULS
MODULE SEMI-CONDUCTEUR DE PUISSANCE COMPRENANT UN CONNECTEUR DE SIGNAL ÉLECTRIQUE FLEXIBLE INTÉGRÉ ET PROCÉDÉ DE PRODUCTION D'UN MODULE SEMI-CONDUCTEUR DE PUISSANCE

(43) Date of publication of application: 01.01.2025
(73) Proprietor: Hitachi Energy Ltd, 8050 Zürich (CH)
(72) Inventor: EHRBAR, Roman, 8037 Zürich (CH); SANTOLARIA, Lluis, 4600 Olten (CH); TRUESSEL, Dominik, 5620 Bremgarten (CH)
(74) Representative: Epping - Hermann - Fischer

(56) References cited:
- JP-A- 2004 319 740
- US-A- 5 508 556
- US-A1- 2009 200 066
- US-A1- 2011 217 877
- US-A1- 2020 127 181
- US-A1- 2021 296 190

## Description

The present disclosure relates to a power semiconductor module comprising at least one embedded flexible electrical signal connector and a method for producing a power semiconductor module.

Power semiconductor modules require not only power connections between power terminals and power semiconductor devices, but often also multiple signal connections for different purposes, for instance for controlling the power semiconductor devices, for sensing of power circuit, and/or for sensor reading. Signal connections can be realized by terminal structures, wherein interconnections between the terminal structures can be provided by terminals made of stamped and bent metal sheets. As an alternative, a printed circuit board can used for electrically connecting power module substrates to internal or external control electronics.

The realization of the control circuit with multiple signal connections causes large effort and costs. If the interconnections are realized by terminals made of metal sheets, it is desirable that multiple terminals with different designs shall be manufactured by individual stamping and bending processes accompanied by high tooling and manufacturing costs. When using a printed circuit board, the material costs of the printed circuit board may be lower, but a complicated manufacturing or assembly process is needed for the connection with the external auxiliary terminals and for the preparation e.g. of vertical wire-bond connections between the printed circuit board and the power module substrates for providing internal connections. Thus, it is desirable to reduce costs and efforts for instance in the implementation of signal connections inside a power semiconductor module.

Document US 2021/296190 A1 describes a semiconductor device in which a semiconductor element mounted on a laminate substrate and an electrically conductive connection member are sealed with a sealing material. The semiconductor device includes a primer layer in an interface between the sealing material and sealed members.

Document US 2011 /217877 A1 describes a method connecting two parts, which overlap each other only partially and have electrically conducting structures, mechanically and electrically at the same time. For purposes of electrical insulation and/or for mechanical and/or chemical protection, at least one of the conductors is extensively covered with an electrically insulating material beyond the overlapping area and including the connection surface adhesive is brought into a permanently adhering state.

Document US 2009/200066 A1 describes a microelectronic chip which comprises two parallel main faces and side faces. At least one of the faces comprises a recess provided with at least one electrical connection element and forming a housing for a wire element. The wire element simultaneously constitutes both an electrical connection between the chip and the outside via said connection element and a flexible mechanical support for said chip.

Document US 5 508 556 A relates to a semiconductor die mounted over a power supply surface. Signal bonding pads on the die are wire bonded to corresponding leads of a leadframe. Power supply bonding pads on the die are wire bonded to the power supply surface. A package body surrounds the semiconductor die, the wire bonds, and the power supply surface.

Document US 2009/120668 A1 relates to an assembly for conducting an electronic signal. The assembly includes a substrate and an electronic cable. The substrate has distinct first and second regions to enable connection to first and second circuit boards, respectively. First and second through-holes are formed in the substrate in the first and second regions, respectively. The electronic cable is disposed within the first through-hole and extends out of the first through hole, adjacent the substrate and into the second through-hole.

Embodiments of this disclosure, as claimed in the independent claims, address the above shortcomings in the art in whole or in part. Further embodiments of the power semiconductor module and of the method for producing a power semiconductor module are subject matter of the further claims.

The present invention is set out by the set of appended claims. In the following, parts of the description and drawing referring to examples or implementations, which are not covered by the claims are not presented as embodiments of the invention, but as illustrative examples useful for understanding the invention.

According to the invention, there is disclosed a power semiconductor module as recited in claim 1.

Since the internal electrical signal connector itself is mechanically flexible and nevertheless it may have a stable shape, in the absence of the sealing material, for instance before the sealing material is applied onto the signal connector, the internal electrical signal connector is freely configurable in three dimensions and thus can take any pre-designed position in three dimensions in the power semiconductor module. For example, the signal connector is pre-fabricated. The signal connector is electrically connected to the first module part and/or the second module part. Once the signal connector is located at pre-designed position in three dimensions in the power semiconductor module, the signal connector can be partly or completely embedded within the sealing material. The signal connector may have a stable shape, such that an unwanted change of the shape is prevented. The shape, however, may be manually adjusted when the signal connector is arranged inside the power semiconductor module.

Hence, using mechanically flexible connector/s makes it possible to have flexible interconnection/s between different module parts of the power semiconductor module. The shape/s of the mechanically flexible connector/s can be adjusted for instance during the assembly process according to individual requirements. The mechanically flexible connector or the flexible interconnection can be at least partly or fully embedded in the sealing material of the power semiconductor module itself or into a building block like a terminal block. Here, at least parts of the flexible conductor/s or the whole flexible conductor/s of the signal connector can be directly embedded in the sealing material, or the flexible conductor/s can be arranged on or within a mechanically flexible and electrically isolating structure for instance in form of a carrier before the signal connector is embedded into the sealing material.

The term "internal electrical signal connector" may describe a flexible control/measurement signal distribution element and may function as a mechanically flexible electrical conductor/trunk within a power semiconductor module and can provide at least one electrical connection between at least one power device, for instance a switch, in the power semiconductor module and a terminal, for instance in form of a pin, of the power semiconductor module. The signal connector may be used for establishing an electrical signal connection between one or more power devices in the power semiconductor module, or for establishing an external connection for a signal from or to the one or more power devices in the power semiconductor module. The internal electrical signal connector is characterized by its mechanical or position flexibility for instance with regard to bending and placement properties. For example, the placement is configurable in 3 dimensions for saving spaces and achieving electromagnetic advantages. The signal connector is at least partly embedded within the sealing material, wherein the signal connector can be secured in space by additional fixing means.

It is also possible that the power semiconductor module comprises at least two or several signal carrying conductors adapted in one single internal electrical signal connector. The two or several signal carrying conductors can be flexibly placed with respect to each other, wherein distances, angles and orientations between the two or several signal carrying conductors can be adjusted according to design requirements for instance for reducing or adjusting electromagnetic coupling, electromagnetic interaction, minimal length or shielding. Here, the length also refers to electromagnetic self-inductance. For example, the signal connector can comprise multiple conducting wires woven close to each other, and at same potential it can provide an electrical effect of a plane. It is also possible to have one or more grounded conductor/s in between two signal carrying conductors to reduce or break the capacitor coupling between the two signal conductors and/or to achieve additional shielding effect.

According to the invention, the internal electrical signal connector comprises an electrically isolating structure, wherein the signal conductor is located on or within the electrically isolating structure. For example, the electrically isolating structure forms a mechanically flexible carrier. Alternatively or in addition, in an embodiment not forming part of the invention, the internal electrical signal connection can be formed by an electrically conductive mesh structure or by an electrically conductive fabric of several litz or stranded wires. It is possible that the signal connector comprises cable/s, coaxial or twisted wires/cables, litz wire (insulated braided/stranded wire/s), wire mesh (braided wires) or wire/s with flexible supporting trunk substrate/s for instance in form of insulating carrier/s. A mechanically flexible connector comprising electrical conductor/s and a flexible supporting trunk substrate may be seen as a mechanically flexible printed circuit board.

According to a further embodiment of the invention, the internal electrical signal connector comprises the at least one signal conductor as a first signal conductor, for instance connecting a first module part with a second module part, and further comprises a second signal conductor, for instance connecting another or same first module part with another second module part. A length of first signal conductor can be different from a length of the second signal conductor, for instance in the internal electrical signal connector. For instance, the length of first signal conductor can differ from the length of the second signal conductor by at least 10 %, 20 %, 30 %, 50 %, 80 % or 150 **%.** It is also possible that the internal electrical signal connector comprises more than two signal conductors, for example at least 3, 4, or 5**.**

According to a further embodiment of the power semiconductor module, the location of the first signal conductor comprised in the internal electrical signal connector is at least partially fixed with respect to the second signal conductor. The location of the first signal conductor comprised in the internal electrical signal connector, however, can be at least partially flexibly located with respect to the second signal conductor. For example, even after the first signal conductor and/or the second signal conductor have been electrically connected to different module parts, for instance to different terminals or auxiliary terminals, there are still possibilities to change the positions and orientations of at least parts of the first signal conductor with respect to the second signal conductor. The relative position and orientation between the first signal conductor and the second signal conductor can be fixed by using additional fixing elements before applying the sealing material onto the electrical signal connector.

According to the invention, the power semiconductor module comprises at least a first internal electrical signal connector and a second internal electrical signal connector. The first internal electrical signal connector and/or the second internal electrical signal connector can be any internal electrical signal connector described here in this disclosure. The first connector can be flexibly located with respect to the second connector within the power semiconductor module. For example, there are still possibilities to change the positions and orientations of the first internal signal connector with respect to the second internal signal connector.

According to a further embodiment of the power semiconductor module, the pre-designed position in three dimensions in the power semiconductor module is laid out to reduce a length of the at least one signal conductor, and/or to reduce and/or adjust an electrical coupling between the signal conductor and at least one of the first module part and the second module part. Alternatively, it can use available space given by the module setup, such that the module size may be smaller, because no extra space is necessary for signal interconnections.

According to a further embodiment of the power semiconductor module, the internal electrical signal connector comprises an electrically isolating structure. The signal conductor can be located on or within the electrically isolating structure. The electrically isolating structure can be a flexible carrier formed by electrically isolating spun yarns. For instance, the signal conductor is spun with the electrically isolating yarns. It is possible, that the connector comprises a plurality of different signal conductors which are spun with the electrically isolating yarns. Each of the different signal conductors can be insulated, if they are used for different purposes. If the conductors are used for the same signal, however, they can be uninsulated.

According to a further embodiment of the power semiconductor module, the internal electrical signal connector comprises an electrically isolating structure. The signal conductor is located for instance on or within the electrically isolating structure being a flexible carrier. The flexible carrier can be flat or sheet-like. The flexible carrier can be in the form of an electrically isolating mesh structure or of an electrically isolating woven fabric or woven sheet.

According to a further embodiment of the power semiconductor module, the internal electrical signal connector comprises at least two or several signal conductors separated from each other. The at least two or several signal conductors can be located on a top and/or a bottom surface of the electrically isolating mesh structure or of the electrically isolating woven fabric or woven sheet. It is possible that the at least two or several signal conductors can cross or overlap each other. At positions, where the at least two or several signal conductors cross each other, they can be located on different surfaces of the flexible carrier which can be flat or sheet-like. It is also possible that each of the at least two or several signal conductors has an electrically isolating shell or coating.

According to a further embodiment of the power semiconductor module, the internal electrical signal connector comprises at least two or several signal conductors separated from each other. The at least two or several signal conductors can be integrated into the electrically isolating mesh structure or into the electrically isolating woven fabric or woven sheet. Thus, in this case, the electrically isolating structure being the mesh structure, the woven fabric or the woven sheet can electrically isolate the at least two or several signal conductors from each other, for instance in a lateral direction and/or in a thickness direction in case of overlap. The distances or orientations of the conductors can be adjusted by the manner how the conductors, for instance in form of uninsulated or insulated wires, are integrated in the electrically isolating structure. In addition, the shape of the electrically isolating structure, for instance in form of sheet, can be adjusted due to its mechanical flexibility.

According to a further embodiment of the power semiconductor module, the internal electrical signal connector comprises an electrically isolating structure being a flexible carrier. The at least one signal conductor can be located on the flexible carrier. For instance, the flexible carrier is in the form of an electrically isolating rod or tube, wherein the at least one signal conductor is wound around and/or arranged along the electrically isolating rod or tube. The electrically isolating rod or tube can also be a thick strand or fiber. The at least one signal conductor can be an uninsulated or insulated wire or cable. It is also possible that the signal connector comprises a plurality of signal conductors being wound around and/or arranged along the electrically isolating rod or tube.

According to a further embodiment of the invention, the internal electrical signal connector comprises an electrically isolating structure, wherein the signal conductor is located on the electrically isolating structure and the electrically isolating structure is a flexible or bendable carrier. The flexible or bendable carrier comprises at least one groove-like structure and/or a plurality of fixing elements. The at least one signal conductor is arranged at least partly in the at least one groove-like structure and/or is fixed to the flexible or bendable carrier by the fixing elements.

It is possible that the mechanically flexible internal electrical signal connector comprises at least two or several signal conductors, wherein different signal conductors form different signal paths. The flexible or bendable carrier can comprise at least two or several groove-like structures and/or a plurality of fixing elements. Different signal conductors can be arranged at least partly in different groove-like structures and/or can be fixed to the flexible or bendable carrier at pre-determined positions by the plurality of fixing elements.

According to a further embodiment of the power semiconductor module, the internal electrical signal connector comprises an electrically isolating structure, wherein the at least one signal conductor is located at least partially within the electrically isolating structure. The at least one signal conductor comprises at least one cable wire or coaxial cable wires, wherein the electrically isolating structure forms an electrical isolation around the at least one cable wire and/or around the coaxial cable wires.

According to a further embodiment of the power semiconductor module, the internal electrical signal connector comprises at least two or several signal conductors, wherein different signal conductors form different signal paths isolated from each other. The internal electrical signal conductors can cross or overlap each other, or can be braided or twisted into each other.

According to a further example of the power semiconductor module, the at least one signal conductor is formed by an electrically conductive mesh structure or by an electrically conductive fabric of several litz or stranded or knitted wires. Part of the at least one signal conductor or the whole at least one signal conductor can be directly embedded in the sealing material so that the sealing material is in direct contact with the electrically conductive mesh structure or with the electrically conductive fabric. The electrically conductive mesh structure and the electrically conductive fabric of several litz or stranded or knitted wires in each case are formed to be mechanically flexible. It is possible that part of the at least one signal conductor is embedded in a terminal block.

According to the invention, there is disclosed a method for producing a power semiconductor module as recited in claim 8.

The electrical signal connector can be pre-fabricated. Signal conductor/s of the electrical signal connector are electrically connected to the first module part and/or to second module part. Before the step of applying the sealing material, the electrical signal connector is configurable in three dimensions. Due to its mechanical flexibility, the internal electrical signal connector can be adjusted to pre-designed positions in three dimensions. It is also possible that the electrically isolating structure and/or the signal conductor/s of the electrical signal connector are configurable in three dimensions. For instance, the electrically isolating structure or the signal conductor can be stretched, bent, rolled, folded or mechanically deformed such that the electrically isolating structure or the signal conductor is adjusted to the geometry or inner space of the power semiconductor module. It is also possible that the positions of the signal conductor/s on or within the electrically isolating structure are adjusted or adapted before the step of applying the sealing material. Thus, even after providing the interconnection, an adjustment of the geometry of the signal connector or of the signal conductor/s is still possible before applying the sealing step.

The present disclosure comprises several aspects of a power semiconductor module and of a method for producing a power semiconductor module on the basis of their embodiments and examples. Every feature described with respect to one of the embodiments is also disclosed herein with respect to the other embodiment, even if the respective feature is not explicitly mentioned in the context of the specific embodiment. For example, the method for producing a power semiconductor module described above is particularly suitable for the production of the power semiconductor module described here. Thus, features and advantages described in connection with the power semiconductor module can therefore be used for the method, and vice versa.

While the disclosure is amenable to various modifications and alternative forms, specifics thereof are shown by way of example in the figures and will be described in detail. It should be understood, however, that the intention is not to limit the disclosure to the particular described embodiments and examples.

The accompanying figures are included to provide a further understanding. In the figures, elements of the same structure and/or functionality may be assigned to the same reference signs. It is to be understood that the examples shown in the figures are illustrative representations and are not necessarily true to scale.
Figures 1A and 1B show general concepts of a power semiconductor module according to two examples.
Figure 2 shows the power semiconductor module according to an example.
Figure 3 shows the power semiconductor module according to another example.
Figures 4, 5, 6, 7, 8A, 8B, 8C, 9A and 9B show some concrete realizations of a flexible signal connector according to some specific examples.
Figures 10 and 11 show further examples of the power semiconductor module.

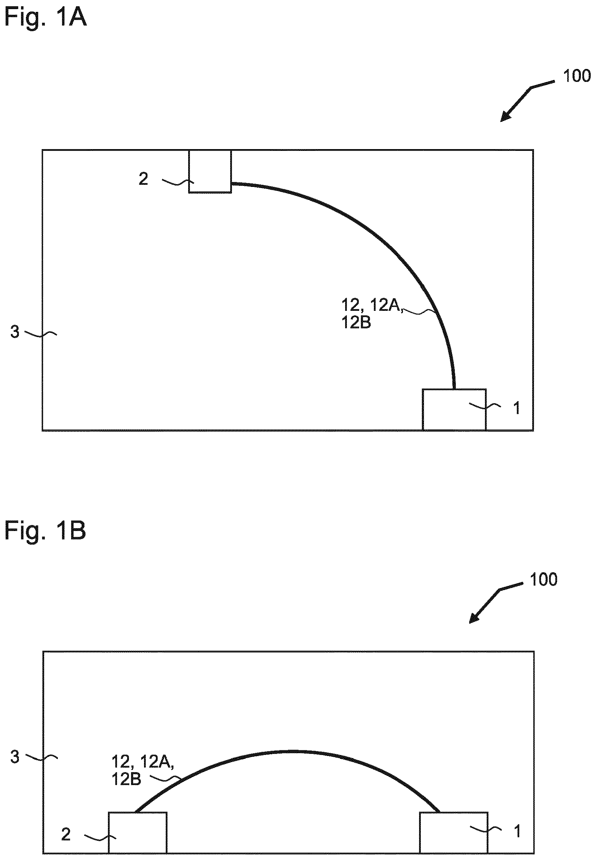

Figure 1A shows a general concept of a power semiconductor module 100 according to an example. The power semiconductor module 100 comprises a first module part 1, a second module part 2, an internal electrical signal connector 12 and a sealing material 3. The internal electrical signal connector 12 can comprises one signal conductor 12A or 12B or at least two or several signal conductors 12A and 12B.

The internal electrical signal connector 12 as a whole is mechanically flexible. The internal electrical signal connector 12 is at least partly or completely embedded within the sealing material 3. In the absence of the sealing material 3, due to its mechanical flexibility, the internal electrical signal connector 12 is geometrically configurable in three dimensions. In other words, in the absence of the sealing material 3, the position of the signal connector 12 and/or of the signal conductor 12A and/or 12B is adjustable within the power semiconductor module 100. It is possible that the signal connector 12 can be stretched, bent, rolled or twisted. In the presence of the sealing material, the internal electrical signal connector 12 or the signal conductor 12A or 12B is located at pre-designed position in three dimensions in the power semiconductor module 100.

Thus, the use of a mechanically flexible internal electrical signal connector 12 can result in improved degrees of freedom for the design of signal path/s. In addition, a reduced coupling inductance for instance of a gate-emitter or gate-source loop is possible, when the signal conductors 12A and 12B are arranged very next to each other or have a coaxial allocation. Additionally, it can be further helpful, to adjust the coupling induction by suitable positioning of the signal conductors 12A and 12B with respect to the main terminals, i.e. with respect to the power terminals.

As shown in Figure 1A, the signal conductor 12A or 12B electrically connects the first module part 1 to the second module part 2. In general, the first module part 1 and/or the second module part 2 can be a gate, (auxiliary) emitter / source, (auxiliary) collector / drain, other kinds of auxiliary terminals or contacts. Thus, the first module part 1 can be a terminal, for instance a gate terminal, a source terminal, a drain terminal of a transistor or of switch structure. The second module part 2 can be a terminal connected to an emitter, a terminal connected to a sensor or an auxiliary terminal. For instance, the first module part 1 is an internal terminal and the second module part 2 is an external auxiliary terminal. The signal conductor 12A or 12B can form a control/ measurement signal path between the first module part 1 and the second module part 2. The control/ measurement signal path differs from a main power supply path. Thus, the internal electrical signal connector 12 or the signal conductor 12A or 12B, for example, is not configured for forming a power connection between power terminals. Nevertheless, the connector 12 may be used to contact main contacts of a chip for sensing purposes, for instance for auxiliary emitter / source.

It is possible that the first module part 1 is a terminal electrically connected to an internal semiconductor device and the second module part 2 is an auxiliary terminal electrically connected to an external or internal control circuit part associated with the power semiconductor module. This is schematically shown for instance in Figure 1B**.** Hence, the internal electrical signal connector 12 can form an internal electrical signal connection being a gate connection, an emitter connection, a source connection, a collector, a drain connection or a sensor connection or the like. Nevertheless, it is possible that the module part 1 may be a main terminal, wherein the connector 12 is connected to the main terminal. For example, an auxiliary emitter / source or collector / drain, which is used for sensing, can be connected to the corresponding main terminal.

As shown in Figure 1A, the first module part 1 is located at a bottom region of the power semiconductor module 100. For instance, the first module part 1 is arranged on a substrate or is a substrate of the power semiconductor module 100. In Figure 1A, the second module part 2 is located at a top region of the power semiconductor module 100. The second module part 2 can be a control board or an auxiliary terminal which can have a pin structure. The second module part 2 can be a terminal of an auxiliary emitter / source, auxiliary collector / drain, gate or a terminal of a sensor. It is also possible that the first module part 1 or the second module part 2 forms a terminal block. The terminal block can incorporate several main and/or auxiliary terminals. The terminal block may also incorporate at least partly the connector 12**.**

As shown in Figure 1B, both the first module part 1 and the second module part 2 are located at a bottom region of the power semiconductor module 100. The internal electrical signal connector 12 can form internal interconnections for instance between switches or sensors and control devices.

Some possible implementations of the internal electrical signal connector 12 may comprise cables, for instance single cables, cables with multiple wires, multicore wires, twisted single cables, coaxial cables or electrically conductive fabric made of a mesh structure or made of multiple litzes or strands. Further implementations of the internal electrical signal connector 12 may comprise metal filaments arranged around carrier material, metallic filament/s integrated into spun yarns made of an isolating base material, one or more metallic filaments or spun yarns wound around an electrically isolating flexible carrier, one or more thin signal wires integrated into an electrically isolating mesh structure or integrated into an electrically isolating woven fabric or woven sheet, or one or more thin signal wires arranged on a flexible carrier or fixed to a flexible carrier, for instance by clipping.

Thus, the signal conductor/s 12A and/or 12B of the signal connector 12 may form flexible electrical connection/s which is/are directly embedded in the sealing material. It is also possible that the flexible signal conductor/s 12A and/or 12B of the signal connector 12 may be arranged on or within an electrically isolating and flexible carrier of the signal connector 12, wherein the signal connector 12 is at least partly or completely embedded in the sealing material 3. The signal connector 12 may include the flexible carrier.

The use of the mechanically flexible internal electrical signal connector 12 provides many possibilities for realizing signal connections inside the power semiconductor module 100 with reduced costs and effort. These possibilities are based on flexible interconnections, which are at least partly embedded in the sealing material 3 of the power semiconductor module 100 itself or in a terminal block, where multiple terminals are incorporated into the terminal block for instance in form of a resin body. Such a terminal block may incorporate both, main and signal terminals / connectors.

The sealing material 3 may be a dielectric gel, a rubber material, a glue or a potting resin, for instance an epoxy resin. The sealing material may contain filler like inorganic fibers or particles. The sealing material 3 can also be a transfer or injection molded resin, for instance in case of a terminal block. Nevertheless, also a complete module housing may be prepared by molding. The transfer molded resin can be an epoxy resin or thermosetting resin. At least part of the sealing may be performed during an assembly process of the power semiconductor module 100, e.g. when the semiconductor module 100 is filled with the sealing material 3 being for instance a dielectric gel, a rubber material, a glue or a potting resin. Other parts of the internal electrical signal connector 12 can be embedded in a separate building block like the terminal block, which may be manufactured by injection or transfer molding a thermoplastic or thermosetting material, for example.

The connection between the signal conductor 12A or 12B and the first module part 1 or the connection between the signal conductor 12A or 12B and the second module part 2 can be performed by method like soldering, sintering, gluing, welding, screwing, hooking or clamping for instance in case of springs.

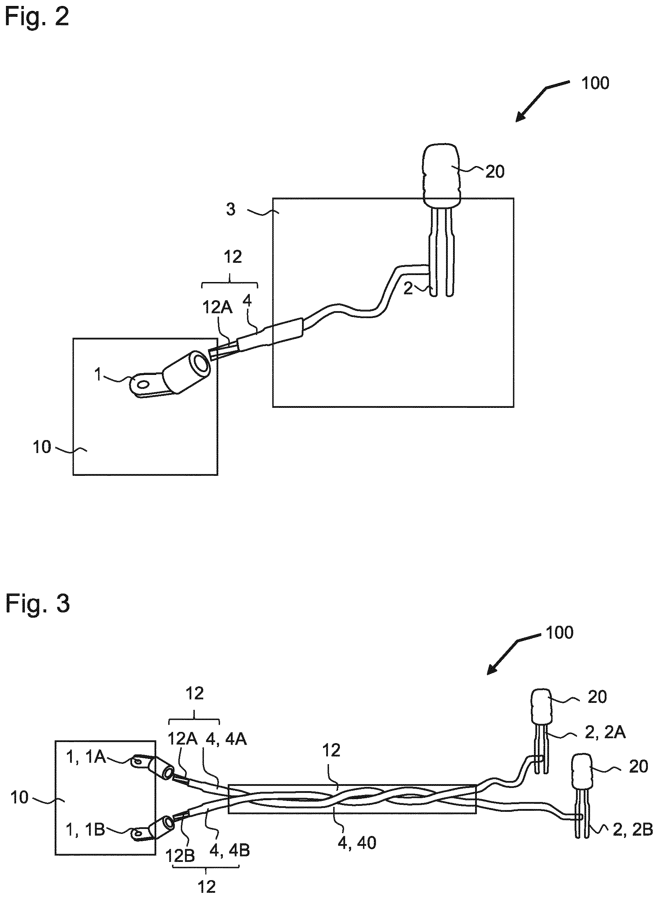

Figure 2 shows an example of the power semiconductor module 100 comprising the internal electrical signal connector 12 being a cable. The first module part 1 can be a terminal connected to a first control circuit part 10 and the second module part 2 can be an auxiliary terminal connected to a second control circuit part 20. The second module part 2 can have a pin structure.

The signal connector 12 comprises an electrically isolating structure 4 and a signal conductor 12A, wherein the signal conductor 12A is located within the electrically isolating structure 4. The signal connector 12 according to Figure 2 is thus a flexible cable, wherein the electrically isolating structure 4 forms an electrical isolation around the signal conductor 12A being a wire used for electrical signal connection. In this sense, the electrically isolating structure 4 forms a flexible carrier for the signal conductor 12A.

The signal connector 12 can provide a direct interconnection between the first module part 1 and the second module part 2 being for instance an external auxiliary terminal. Electrical and mechanical contact between the signal conductor 12A and the first module part 1 or between the signal conductor 12A and the second module part 2 may be realized by joining methods like soldering, sintering, gluing, welding, or clamping or hooking (dry contact).

Due to the electrical isolation provided by the electrically isolating structure 4, no further additional carrier or coating coverage is needed, eventually except from the final embedding into the sealing material 3 of the power semiconductor module 100 or into a building block. So there is a high flexibility when locating the signal connector 12 inside the power semiconductor module 100. Nevertheless, it is possible to provide a fixation of the signal connector 12 for instance to a housing structure e.g. by clips or snap-fits.

Figure 2 shows a possible setup of a signal interconnection realized by the signal connector 12 between the first control circuit part 10 and the second module part 2 being for instance an auxiliary terminal connected to the second control circuit part 20. Here, the signal connector 12 is realized by a cable being connected to the joining partners for instance by ultrasonic welding.

Figure 3 shows an example of the power semiconductor module 100 forming part of the invention, comprising the internal electrical signal connector 12, wherein the signal connector 12 comprises at least two signal conductors 12A and 12B. Each of the conductors 12A and 12B is surrounded by an electrically isolating structure 4. For instance, a first electrically isolating structure 4B and a first signal conductor 12A forms a first cable very similar to the cable shown in Figure 2. A second electrically isolating structure 4B and a second signal conductor 12B forms a second cable very similar to the cable shown in Figure 2. Thus, compared to the example described in Figure 2, according to Figure 3, the signal connector 12 comprises two cables.

As shown in Figure 3, the signal conductors 12A and 12B or the two cables are twisted or braided into each other. The signal connector 12 further comprises an electrically isolating structure 40 which is a common flexible electrically isolating structure 40 and thus forms a common flexible carrier for the signal conductors 12A and 12B. The common flexible electrically isolating structure 40 can be made of plastic or rubber. The common flexible electrically isolating structure 40, however, can be optional. Compared to the example shown in Figure 2, the power semiconductor module 100 according to the example shown in Figure 3 comprises a first module part 1A, a further first module part 1B, a second module part 2A and a further second module part 2B. The first module part 1A and the further first module part 1B can be metallization patterns for instance on the substrate. The second module part 2A and the further second module part 2B may be auxiliary terminals, for instance pin-shaped auxiliary terminals, each connected to one second control circuit part 20. In deviation from Figure 3, it is also possible that the signal connector 12 comprises more than two cables, for instance at least three or four cables, which can be twisted or braided into each other.

Thus, the signal connector 12 may comprise arrangements of multiple cables which are arranged very next to each other for improving the electromagnetic behavior, for instance for improving and or adjusting electromagnetic coupling between the conductors 12A and 12B of the connector 12, for instance between a gate and emitter/source, or for improving electromagnetic shielding. In this case, the signal connector 12 can be considered as multicore cable, wherein two or more cables are arranged next each other. For achieving an improved or adjusted electromagnetic behavior, the two or more cables may have a twisted or braided arrangement. Additionally, a shielding effect may be achieved by arrangement of a further conductor between a sensitive conductor and a source of disturbances, or between conductors in general to avoid or reduce any coupling.

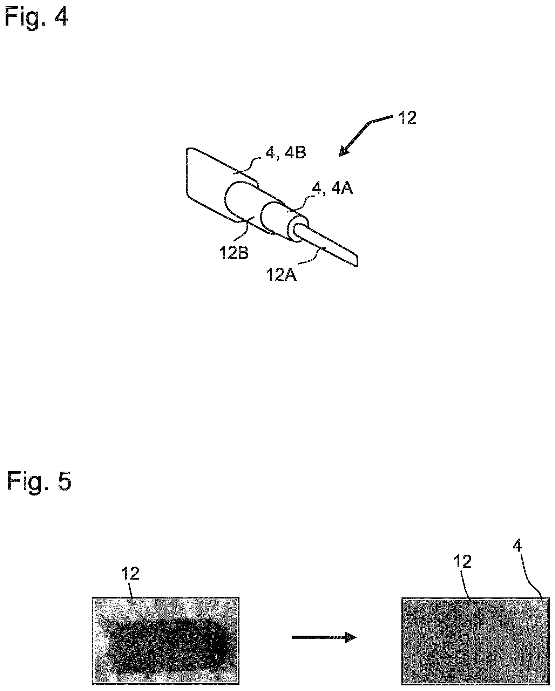

As shown in Figure 4, the signal connector 12 may be realized by a coaxial cable comprising a signal conductor 12A, further signal conductor 12B, a first electrically isolating structure 4A and a second electrically isolating structure 4B. The first electrically isolating structure 4A and the second electrically isolating structure 4B are mechanically flexible and can form flexible carriers for the signal conductors 12A and 12B. The signal conductor 12A is a center core surrounded by the first electrically isolating structure 4A. The further signal conductor 12B forms an outer conductor which surrounds the signal conductor 12A and the first electrically isolating structure 4A. The further signal conductor 12B is surrounded by the second electrically isolating structure 4B.

The signal conductor 12A and further signal conductor 12B can be connected to corresponding module parts of the power semiconductor module, for instance to the first module part/s and to the second module part/s being e.g. auxiliary terminals. The signal conductor 12A as a center core can form a gate signal interconnection. The further signal conductor 12B as outer conductor can form an emitter / source auxiliary signal interconnection.

The signal connector 12 itself or the signal conductor 12A may be formed by a mesh or knitted/woven fabric of multiple thin metal litzes or strands as schematically shown in Figure 5. In other words, as shown in Figure 5, the signal connector 12 or the signal conductor 12B can be formed by an electrically conductive mesh structure or by an electrically conductive fabric of several litz or stranded or knitted wires. The metal mesh or fabric is a compromise between sufficient flexibility for forming and bending the signal connector 12 in arbitrary geometries and sufficient rigidness of the signal connector 12 after mounting, so that it does not undergo significant deformation in a subsequent sealing process, for instance in a subsequent potting or molding process.

When embedding the fabric or mesh into the sealing material 3, the fabric or mesh is penetrated by the sealing material 3 like dielectric gel, potting resin, or molded resin. Thus, it is possible that the signal conductor 12A or 12B is directly embedded in the sealing material 3 so that the sealing material 3 is in direct contact with the electrically conductive mesh structure or with the electrically conductive fabric. Alternatively or in addition, the signal conductor 12A or 12B can be at least partly embedded in a material of a terminal block. Furthermore, it is also possible for the electrically conductive mesh structure or the electrically conductive fabric of several litz or stranded or knitted wires to be covered and or penetrated by electrically isolating structure 4 as shown on the right-hand side on Figure 5.

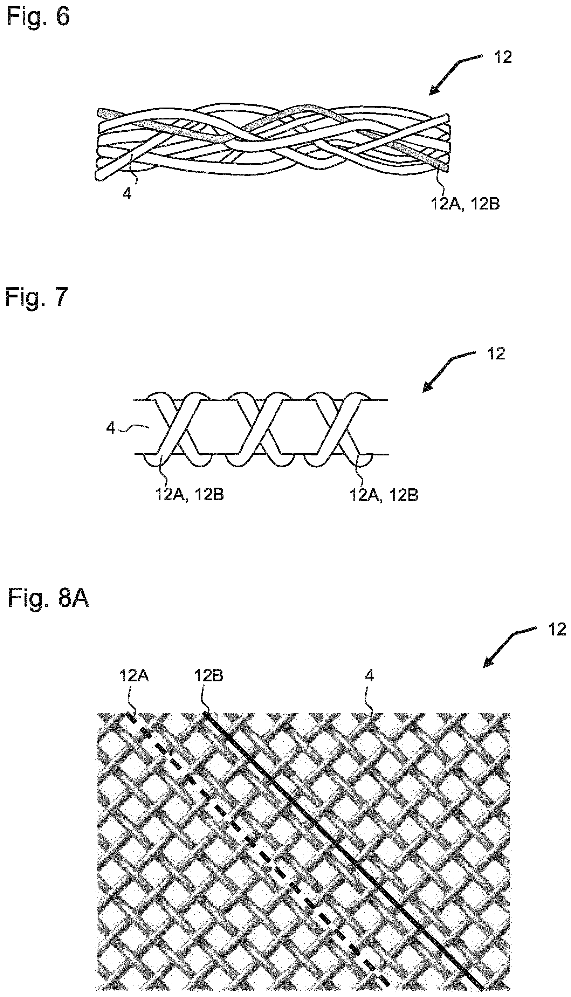

Figures 6 and 7 show some further exemplary implementations of the signal connector 12. The internal electrical signal connector 12 comprises an electrically isolating structure 4, which is mechanically flexible. The signal conductor 12A and/or the further signal conductor 12B are/is located on or within the electrically isolating structure 4. The electrically isolating structure 4 can be used as a carrier.

According to Figure 6, the electrically isolating structure 4 is a flexible carrier formed by electrically isolating spun yarns, wherein the signal conductor 12A or 12B is spun with the electrically isolating yarns. Thus, the electrically isolating yarns in form of fibers or strands are used as carrier material. The isolating yarns may be formed from cotton, polyester or the like. The signal conductor 12A or 12B may be a metallic filament or a metallic wire, which is integrated into a woven yarn structure. The metallic wire may have further isolating coating if multiple conductors for different purpose are implemented.

As an alternative, according to Figure 7, the connector 12 comprises a flexible carrier in the form of an electrically isolating rod or tube which can be a thick strand or fiber. The electrically isolating rod or tube can be seen as a flexible stick, wherein the conductor/s 12A and 12B are wound around and/or arranged along the electrically isolating rod or tube. The flexible carrier is bendable and can be bent according to the geometrical situation inside the power semiconductor module 100. If the multiple conductors 12A and 12B for instance in form of filaments related to different signal paths are implemented, each layer of the conductors 12A and 12B or of the filaments can be coated by electrically isolating material to separate the conductors 12A and 12B from each other. It is also possible to wind one or more spun yarns with incorporated conductors 12A and 12B as shown in Figure 6 around the electrically isolating rod or tube.

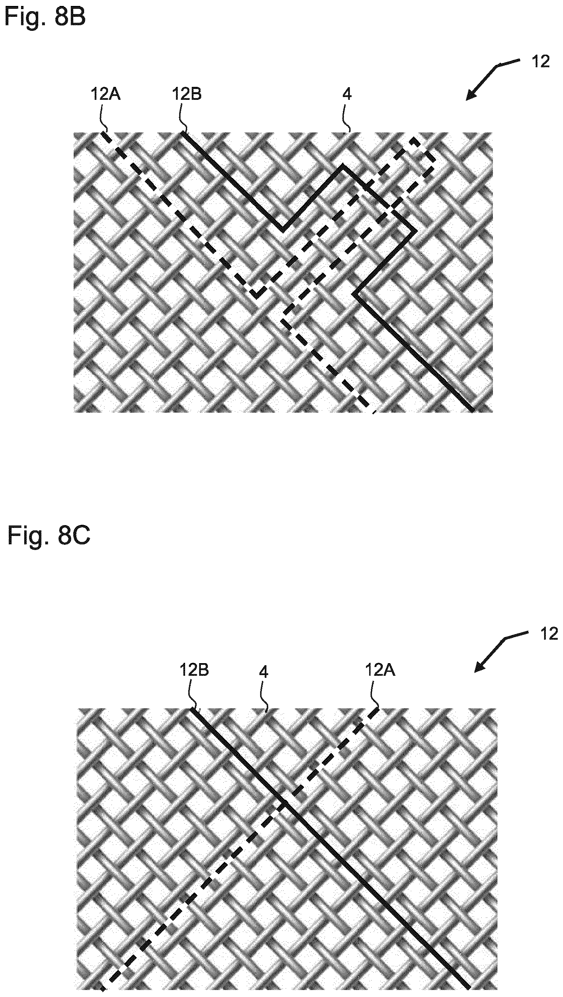

Figures 8A, 8B and 8C show some further exemplary implementations of the signal connector 12, according to which the signal connector 12 comprises an electrically isolating structure 4 being a flat or sheet-like flexible carrier, wherein the flexible carrier is in the form of an electrically isolating mesh structure or of an electrically isolating woven fabric or woven sheet, and wherein the signal conductor 12A is located on or within the flexible carrier.

The signal connector 12 can comprise at least two or more signal conductors 12A and 12B. At positions, where the conductors 12A and 12B may cross or overlap each other, the conductors 12A and 12B may be arranged on different surfaces of the flexible carrier, for instance on a top and/or a bottom surface of the flat or sheet-like electrically isolating mesh structure or of the electrically isolating woven fabric or woven sheet. It is also possible that the at least two or more signal conductors 12A and 12B are separated from each other, when they are integrated in different positions of the electrically isolating mesh structure, woven fabric or woven sheet.

Thus, according to Figures 8A to 8C, the sheet of mesh structure or woven fabric made of electrically isolating material is used as a carrier for one or more conductors 12A and 12B for instance in the form of metallic filaments. For avoiding an electrical short-circuit of the conductors 12A and 12B, the conductors 12A and 12B may also be coated by isolating material. The electrically isolating mesh structure, woven fabric or woven sheet can be made of a flexible material and forms the flexible carrier which provides a compromise between sufficient flexibility for being formed and bent in arbitrary geometries and sufficient rigidness after mounting, such that the flexible carrier together with the conductors 12A and 12B do not undergo deformation during a subsequent sealing process, for instance during a subsequent molding or potting process.

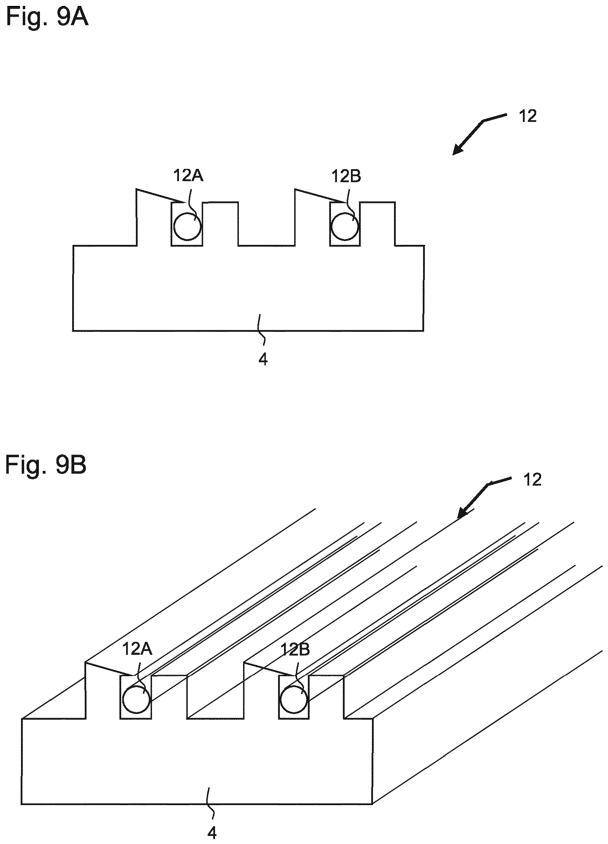

Figures 9A and 9B show some further exemplary implementations forming part of the invention of the signal connector 12, according to which the internal electrical signal connector 12 comprises an electrically isolating structure 4 being a flexible or bendable carrier. The signal conductors 12A and 12B are located on the flexible or bendable carrier. The flexible or bendable carrier can comprise at least one groove-like structure or several groove-like structures for at least partially accommodating the signal conductors 12A and 12B or a plurality of fixing elements for fixing the signal conductors 12A and 12B. Thus, the signal conductors 12A and 12B can be arranged at least partly in the groove-like structures or are fixed to the flexible or bendable carrier by the fixing elements.

Thus, Figures 9A and 9B show at least two signal conductors 12A and 12B for instance in form of metallic filaments or wires which are arranged on or fixed to a stiff but flexible or bendable carrier, which may be adjusted to the geometric situation of the power semiconductor module 100. The carrier itself can be made from an electrically isolating material, for instance from a flexible or bendable resin material or from a rubber material. The signal conductors 12A and 12B can be laid into groove-like structures of the carrier, whose sidewalls provide lateral electrical isolation between the signal conductors 12A and 12B of different signal paths. Alternatively or in addition, the carrier may provide fixing elements like clipping and/or retainer structures for the fixation of the signal conductors 12A and 12B.

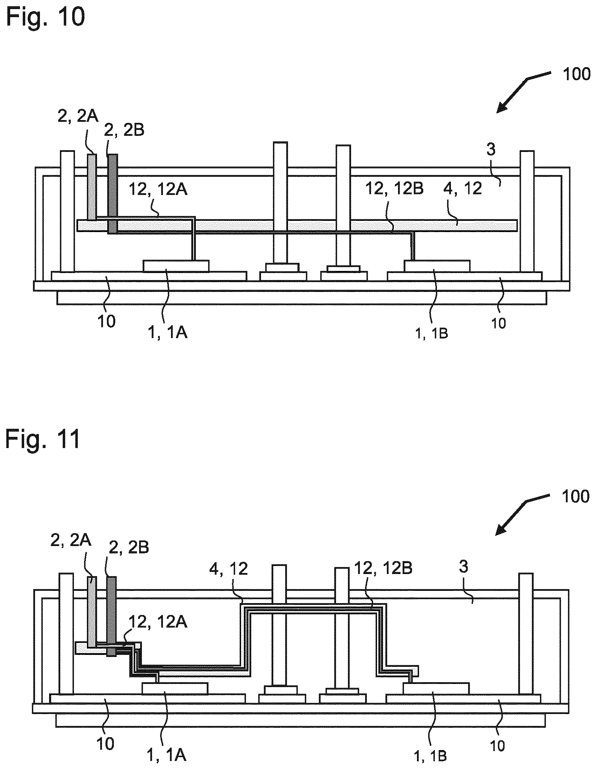

Figures 10 and 11 show further examples of the power semiconductor module 100 comprising an internal electrical signal connector 12 which is mechanically flexible. Thus, the signal connector 12 differs from a printed circuit board, for instance from a rigid printed circuit board having wires arranged thereon. The signal connector 12 is for instance void a carrier which is not flexible or bendable. It is also possible, however, that the signal connector 12 comprises a mechanically flexible printed circuit board.

The signal connector 12 shown in Figures 10 and 11 can be any of the signal connectors 12 described in connection with Figures 1A to 9B. Thus, features and advantages described in connection with the signal connector 12 or with the power semiconductor module 100 shown in 1A to 9B can be used for the signal connector 12 or the power semiconductor module 100 shown in Figure 10 or 11, and vice versa.

As shown in Figures 10 and 11, the signal connector 12 comprises at least two signal conductors 12A and 12B. One signal conductor 12A forms an interconnection between a first module part 1A and a second module part 2A being for instance an auxiliary terminal. The first module part 1A can be a terminal of a first switch. One further signal conductor 12B forms an interconnection between a further first module part 1B and a further second module part 2A being for instance a further auxiliary terminal. The further first module part 1B can be a contact of a second switch or any contact surface. Due to its mechanical flexibility accompanied by sufficient rigidity to keep the shape, the internal electrical signal connector 12 is configurable in three dimensions in the absence of the sealing material 3 and thus can be adapted to any inner geometry of the power semiconductor module 100. Thus, the internal electrical signal connector 12 together with the signal conductors 12A and 12B can be located at any pre-designed position in three dimensions within the power semiconductor module 100. This is shown schematically in Figure 11.

After the position of the internal electrical signal connector 12 or a relative position between the signal conductors 12A and 12B has been fixed and/or after the signal conductor 12A or 12B has been connected to the first module part 1 and/or to the second module part 2, a sealing material 3 can be applied for instance into a housing of the power semiconductor module 100. The internal electrical signal connector 12 can thus be at least partly or fully embedded within the sealing material 3.

The invention is defined by the appended claims.

### Reference Signs

- 100: power semiconductor module
- 10: first control circuit part
- 1: module part/ first module part
- 1A: first module part
- 1B: further first module part
- 12: internal electrical signal connector
- 12A: signal conductor
- 12B: further signal conductor
- 2: module part/ second module part
- 2A: second module part
- 2B: further second module part
- 20: second control circuit part
- 3: sealing material
- 4: electrically isolating structure/ carrier
- 4A: first electrically isolating structure
- 4B: second electrically isolating structure
- 40: common electrically isolating structure/ common carrier

## Claims

1. A power semiconductor module (100) comprising a first module part (1, 1A, 1B), a second module part (2, 2A, 2B), an internal electrical signal connector (12) and a sealing material (3), wherein
- the internal electrical signal connector (12) is mechanically flexible and is electrically connected to the first module part (1, 1A, 1B) and/or the second module part (2, 2A, 2B), wherein signal conductors (12A, 12B) of the internal electrical signal connector (12) are electrically connected to the first module part (1, 1A, 1B) and/or to second module part (2, 2A, 2B),
- the internal electrical signal connector (12) is at least partly embedded within the sealing material (3),
- due to its mechanical flexibility, the internal electrical signal connector (12) is configurable in three dimensions in the absence of the sealing material (3) and is located at pre-designed position in three dimensions in the power semiconductor module (100),
- the internal electrical signal connector (12) comprises a common electrically isolating structure (4) being a common mechanically flexible carrier for the signal conductors (12A, 12B) of the internal electrical signal connector (12),
- the signal conductors (12A, 12B) comprise a first signal conductor (12A) and a second signal conductor (12B), the first signal conductor (12A) and the second signal conductor (12B) being located on or within the common electrically isolating structure (4), and
**characterised in that** the power semiconductor module (100) comprises one additional feature i or ii, namely
i. the common electrically isolating structure (4) being the common mechanically flexible carrier is made of plastic or rubber, wherein the signal conductors (12A, 12B) are located within the common electrically isolating structure (4) and are twisted or braided into each other, wherein the signal conductors (12A, 12B) form different signal paths isolated from each other, or
ii. the signal conductors (12A, 12B) form different signal paths, wherein the common electrically isolating structure (4) being the common mechanically flexible carrier comprises at least two or several groove-like structures or a plurality of fixing elements, and different signal conductors (12A, 12B) are arranged at least partly in different groove-like structures or are fixed to the common mechanically flexible carrier at pre-determined positions by the plurality of fixing elements.

2. The power semiconductor module (100) according to claim 1 comprising the additional feature ii,
wherein a length of the first signal conductor (12A) is different from a length of the second signal conductor (12B).

3. The power semiconductor module (100) according to claim 2, wherein
the first signal conductor (12A) is flexibly located with respect to the second signal conductor (12B) at least partially within power semiconductor module (100), and/or a location of the first signal conductor (12A) comprised in the internal electrical signal connector (12) is at least partially fixed with respect to the second signal conductor (12B).

4. The power semiconductor module (100) according to any of claims 1 to 3 comprising the additional feature ii, wherein the pre-designed position in three dimensions in the power semiconductor module (100) is laid out to
- reduce a length of the first or second signal conductor (12A, 12B), and/or
- reduce and/or adjust an electrical coupling between the signal conductor (12) and at least one of the first module part (1, 1A, 1B) and the second module part (2, 2A, 2B).

5. The power semiconductor module (100) according to any of claims 1 to 4 comprising the additional feature ii, wherein
- the common mechanically flexible carrier comprises at least two or several groove-like structures, and
- different signal conductors (12A, 12B) are arranged at least partly in different groove-like structures.

6. The power semiconductor module (100) according to any of claims 1 to 4 comprising the additional feature ii, wherein the common mechanically flexible carrier comprises the plurality of fixing elements, and
different signal conductors (12A, 12B) are fixed to the common mechanically flexible carrier at pre-determined positions by the plurality of fixing elements.

7. The power semiconductor module (100) according to claim 1 comprising the additional feature i.

8. A method for producing a power semiconductor module (100) comprising a first module part (1, 1A, 1B), a second module part (2, 2A, 2B), one internal electrical signal connector (12) and a sealing material (3), comprising:
providing the power semiconductor module (100) without the sealing material (3),
wherein the internal electrical signal connector (12) is mechanically flexible and is electrically connected to the first module part (1, 1A, 1B) and/or the second module part (2, 2A, 2B), wherein signal conductors (12A, 12B) of the internal electrical signal connector (12) are electrically connected to the first module part (1, 1A, 1B) and/or to second module part (2, 2A, 2B), and
wherein due to its mechanical flexibility, the internal electrical signal connector (12) is configurable in three dimensions and is adjusted to pre-designed position in three dimensions in the power semiconductor module (100); and
applying the sealing material (3) onto the internal electrical signal connector (12) so that the internal electrical signal connector (12) is at least partly embedded within the sealing material (3),
wherein the internal electrical signal connector (12) comprises a common electrically isolating structure (4) being a common mechanically flexible carrier for the signal conductors (12A, 12B) of the internal electrical signal connector (12),
wherein the signal conductors (12A, 12B) comprise a first signal conductor (12A) and a second signal conductor (12B),
the first signal conductor (12A) and the second signal conductor (12B) being located on or within the common electrically isolating structure (4), and
**characterised in that**
the power semiconductor module (100) comprises one additional feature i or ii, namely
i. the common flexible electrically isolating structure (4) is made of plastic or rubber, wherein the signal conductors (12A, 12B) are located within the common electrically isolating structure (4) and are twisted or braided into each other, wherein the signal conductors (12A, 12B) form different signal paths isolated from each other, or
ii. the signal conductors (12A, 12B) form different signal paths, wherein the common mechanically flexible carrier comprises at least two or several groove-like structures or a plurality of fixing elements, and different signal conductors (12A, 12B) are arranged at least partly in different groove-like structures or are fixed to the common mechanically flexible carrier at pre-determined positions by the plurality of fixing elements.

9. The method according to claim 8,
wherein the power semiconductor module (100) comprises the additional feature ii, and
wherein a length of the first signal conductor (12A) is different from a length of the second signal conductor (12B).

10. The method according to claim 9, wherein
the first signal conductor (12A) is flexibly located with respect to the second signal conductor (12B) at least partially within power semiconductor module (100), and/or a location of the first signal conductor (12A) comprised in the internal electrical signal connector (12) is at least partially fixed with respect to the second signal conductor (12B).

11. The method according to any of claims 8 to 10, wherein the power semiconductor module (100) comprises the additional feature ii, and wherein
the pre-designed position in three dimensions in the power semiconductor module (100) is laid out to
- reduce a length of the first or second signal conductor (12A, 12B), and/or
- reduce and/or adjust an electrical coupling between the signal conductor (12) and at least one of the first module part (1, 1A, 1B) and the second module part (2, 2A, 2B).

12. The method according to any of claims 8 to 11, wherein
- the power semiconductor module (100) comprises the additional feature ii,
- the common mechanically flexible carrier comprises at least two or several groove-like structures, and
- different signal conductors (12A, 12B) are arranged at least partly in different groove-like structures.

13. The method according to any of claims 8 to 11, wherein
- the power semiconductor module (100) comprises the additional feature ii,
- the common mechanically flexible carrier comprises a plurality of fixing elements, and
- different signal conductors (12A, 12B) are fixed to the common mechanically flexible carrier at pre-determined positions by the plurality of fixing elements.

14. The method according to claim 8, wherein the power semiconductor module (100) comprises the additional feature i.

## Patentansprüche

1. Leistungshalbleitermodul (100), das ein erstes Modulbauteil (1, 1A, 1B), ein zweites Modulbauteil (2, 2A, 2B), einen internen elektrischen Signalverbinder (12) und ein Abdichtmaterial (3) umfasst, wobei
- der interne elektrische Signalverbinder (12) mechanisch flexibel ist und elektrisch mit dem ersten Modulbauteil (1, 1A, 1B) und/oder dem zweiten Modulbauteil (2, 2A, 2B) verbunden ist, wobei Signalleiter (12A, 12B) des internen elektrischen Signalverbinders (12) mit dem ersten Modulbauteil (1, 1A, 1B) und/oder dem zweiten Modulbauteil (2, 2A, 2B) elektrisch verbunden sind,
- der interne elektrische Signalverbinder (12) mindestens teilweise innerhalb des Abdichtmaterials (3) eingebettet ist,
- der interne elektrische Signalverbinder (12), aufgrund seiner mechanischen Flexibilität, bei der Abwesenheit des Abdichtmaterials (3) in drei Dimensionen konfigurierbar ist und sich an einer in drei Dimensionen vordefinierten Position in dem Leistungshalbleitermodul (100) befindet,
- der interne elektrische Signalverbinder (12) eine gemeinsame elektrisch isolierende Struktur (4) umfasst, die ein gemeinsamer mechanisch flexibler Träger für die Signalleiter (12A, 12B) des internen elektrischen Signalverbinders (12) ist,
- die Signalleiter (12A, 12B) einen ersten Signalleiter (12A) und einen zweiten Signalleiter (12B) umfassen, wobei sich der erste Signalleiter (12A) und der zweite Signalleiter (12B) auf oder innerhalb der gemeinsamen elektrisch isolierenden Struktur (4) befinden, und
**dadurch gekennzeichnet, dass**
das Leistungshalbleitermodul (100) ein zusätzliches Merkmal i oder ii umfasst, nämlich dass
i. die gemeinsame elektrisch isolierende Struktur (4), die der gemeinsame mechanisch flexible Träger ist, aus einem Kunststoff oder einem Kautschuk gefertigt ist, wobei sich die Signalleiter (12A, 12B) innerhalb der gemeinsamen elektrisch isolierenden Struktur (4) befinden und miteinander verdrillt oder verflochten sind, wobei die Signalleiter (12A, 12B) unterschiedliche Signalwege bilden, die voneinander isoliert sind, oder
ii. die Signalleiter (12A, 12B) unterschiedliche Signalwege bilden, wobei die gemeinsame elektrisch isolierende Struktur (4), die der gemeinsame mechanisch flexible Träger ist, mindestens zwei oder mehrere nutartige Strukturen oder eine Vielzahl von Befestigungselementen umfasst, und wobei verschiedene Signalleiter (12A, 12B) mindestens teilweise in unterschiedlichen nutartigen Strukturen angeordnet sind oder an vorbestimmten Positionen durch die Vielzahl von Befestigungselementen an dem gemeinsamen mechanisch flexiblen Träger befestigt sind.

2. Leistungshalbleitermodul (100) nach Anspruch 1, welches das zusätzliche Merkmal ii umfasst,
wobei eine Länge des ersten Signalleiters (12A) verschieden von einer Länge des zweiten Signalleiters (12B) ist.

3. Leistungshalbleitermodul (100) nach Anspruch 2, wobei der erste Signalleiter (12A) in Bezug auf den zweiten Signalleiter (12B) mindestens teilweise innerhalb des Leistungshalbleitermoduls (100) flexibel angebracht ist, und/oder ein Ort des ersten Signalleiters (12A), der in dem internen elektrischen Signalverbinder (12) enthalten ist, in Bezug auf den zweiten Signalleiter (12B) mindestens teilweise fixiert ist.

4. Leistungshalbleitermodul (100) nach einem der Ansprüche 1 bis 3, welches das zusätzliche Merkmal ii umfasst,
wobei die in drei Dimensionen vordefinierte Position in dem Leistungshalbleitermodul (100) ausgelegt ist zum
- Verringern einer Länge des ersten oder des zweiten Signalleiters (12A, 12B), und/oder
- Verringern und/oder Anpassen einer elektrischen Kopplung zwischen dem Signalleiter (12) und mindestens einem des ersten Modulbauteils (1, 1A, 1B) und des zweiten Modulbauteils (2, 2A, 2B).

5. Leistungshalbleitermodul (100) nach einem der Ansprüche 1 bis 4, welches das zusätzliche Merkmal ii umfasst, wobei
- der gemeinsame mechanisch flexible Träger mindestens zwei oder mehrere nutartige Strukturen umfasst, und
- verschiedene Signalleiter (12A, 12B) mindestens teilweise in unterschiedlichen nutartigen Strukturen angeordnet sind.

6. Leistungshalbleitermodul (100) nach einem der Ansprüche 1 bis 4, welches das zusätzliche Merkmal ii umfasst, wobei der gemeinsame mechanisch flexible Träger die Vielzahl von Befestigungselementen umfasst und
wobei verschiedene Signalleiter (12A, 12B) an vorbestimmten Positionen durch die Vielzahl von Befestigungselementen an dem gemeinsamen mechanisch flexiblen Träger befestigt sind.

7. Leistungshalbleitermodul (100) nach Anspruch 1, welches das zusätzliche Merkmal i umfasst.

8. Verfahren zum Herstellen eines Leistungshalbleitermoduls (100), das ein erstes Modulbauteil (1, 1A, 1B), ein zweites Modulbauteil (2, 2A, 2B), einen internen elektrischen Signalverbinder (12) und ein Abdichtmaterial (3) umfasst, umfassend:
Bereitstellen des Leistungshalbleitermoduls (100) ohne das Abdichtmaterial (3),
wobei der interne elektrische Signalverbinder (12) mechanisch flexibel ist und elektrisch mit dem ersten Modulbauteil (1, 1A, 1B) und/oder dem zweiten Modulbauteil (2, 2A, 2B) verbunden ist, wobei Signalleiter (12A, 12B) des internen elektrischen Signalverbinders (12) mit dem ersten Modulbauteil (1, 1A, 1B) und/oder dem zweiten Modulbauteil (2, 2A, 2B) elektrisch verbunden sind, und
wobei der interne elektrische Signalverbinder (12), aufgrund seiner mechanischen Flexibilität, in drei Dimensionen konfigurierbar ist und an eine in drei Dimensionen vordefinierten Position in dem Leistungshalbleitermodul (100) angepasst wird,
Anwenden des Abdichtmaterials (3) auf den internen elektrischen Signalverbinder (12), sodass der interne elektrische Signalverbinder (12) mindestens teilweise innerhalb des Abdichtmaterials (3) eingebettet ist,
wobei der interne elektrische Signalverbinder (12) eine gemeinsame elektrisch isolierende Struktur (4) umfasst, die ein gemeinsamer mechanisch flexibler Träger für die Signalleiter (12A, 12B) des internen elektrischen Signalverbinders (12) ist,
wobei die Signalleiter (12A, 12B) einen ersten Signalleiter (12A) und einen zweiten Signalleiter (12B) umfassen, wobei sich der erste Signalleiter (12A) und der zweite Signalleiter (12B) auf oder innerhalb der gemeinsamen elektrisch isolierenden Struktur (4) befinden, und
**dadurch gekennzeichnet, dass** das Leistungshalbleitermodul (100) ein zusätzliches Merkmal i oder ii umfasst, nämlich dass
i. die gemeinsame flexible elektrisch isolierende Struktur (4) aus einem Kunststoff oder einem Kautschuk gefertigt ist, wobei sich die Signalleiter (12A, 12B) innerhalb der gemeinsamen elektrisch isolierenden Struktur (4) befinden und miteinander verdrillt oder verflochten sind, wobei die Signalleiter (12A, 12B) unterschiedliche Signalwege bilden, die voneinander isoliert sind, oder
ii. die Signalleiter (12A, 12B) unterschiedliche Signalwege bilden, wobei der gemeinsame mechanisch flexible Träger mindestens zwei oder mehrere nutartige Strukturen oder eine Vielzahl von Befestigungselementen umfasst, und wobei verschiedene Signalleiter (12A, 12B) mindestens teilweise in unterschiedlichen nutartigen Strukturen angeordnet sind oder an vorbestimmten Positionen durch die Vielzahl von Befestigungselementen an dem gemeinsamen mechanisch flexiblen Träger befestigt sind.

9. Verfahren nach Anspruch 8,
wobei das Leistungshalbleitermodul (100) das zusätzliche Merkmal ii umfasst, und
wobei eine Länge des ersten Signalleiters (12A) verschieden von einer Länge des zweiten Signalleiters (12B) ist.

10. Verfahren nach Anspruch 9, wobei
der erste Signalleiter (12A) in Bezug auf den zweiten Signalleiter (12B) mindestens teilweise innerhalb des Leistungshalbleitermoduls (100) flexibel angebracht ist, und/oder
ein Ort des ersten Signalleiters (12A), der in dem internen elektrischen Signalverbinder (12) enthalten ist, in Bezug auf den zweiten Signalleiter (12B) mindestens teilweise fixiert ist.

11. Verfahren nach einem der Ansprüche 8 bis 10, wobei das Leistungshalbleitermodul (100) das zusätzliche Merkmal ii umfasst und wobei die in drei Dimensionen vordefinierte Position in dem Leistungshalbleitermodul (100) ausgelegt ist zum
- Verringern einer Länge des ersten oder des zweiten Signalleiters (12A, 12B), und/oder
- Verringern und/oder Anpassen einer elektrischen Kopplung zwischen dem Signalleiter (12) und mindestens einem des ersten Modulbauteils (1, 1A, 1B) und des zweiten Modulbauteils (2, 2A, 2B).

12. Verfahren nach einem der Ansprüche 8 bis 11, wobei
- das Leistungshalbleitermodul (100) das zusätzliche Merkmal ii umfasst,
- der gemeinsame mechanisch flexible Träger mindestens zwei oder mehrere nutartige Strukturen umfasst, und
- verschiedene Signalleiter (12A, 12B) mindestens teilweise in unterschiedlichen nutartigen Strukturen angeordnet sind.

13. Verfahren nach einem der Ansprüche 8 bis 11, wobei
- das Leistungshalbleitermodul (100) das zusätzliche Merkmal ii umfasst,
- der gemeinsame flexible Träger eine Vielzahl von Befestigungselementen umfasst, und
- verschiedene Signalleiter (12A, 12B) an vorbestimmten Positionen durch die Vielzahl von Befestigungselementen an dem gemeinsamen mechanisch flexiblen Träger befestigt sind.

14. Verfahren nach Anspruch 8, wobei das Leistungshalbleitermodul (100) das zusätzliche Merkmal i umfasst.

## Revendications

1. Module à semi-conducteur de puissance (100) comprenant une première partie de module (1, 1A, 1B), une deuxième partie de module (2, 2A, 2B), un connecteur de signal électrique interne (12) et un matériau d'étanchéité (3), dans lequel
- le connecteur de signal électrique interne (12) est mécaniquement flexible et est électriquement connecté à la première partie de module (1, 1A, 1B) et/ou à la deuxième partie de module (2, 2A, 2B), des conducteurs de signal (12A, 12B) du connecteur de signal électrique interne (12) étant électriquement connectés à la première partie de module (1, 1A, 1B) et/ou à la deuxième partie de module (2, 2A, 2B),
- le connecteur de signal électrique interne (12) est au moins partiellement encapsulé dans le matériau d'étanchéité (3),
- du fait de sa flexibilité mécanique, le connecteur de signal électrique interne (12) est configurable dans trois dimensions en l'absence du matériau d'étanchéité (3) et occupe une position dans trois dimensions prédéfinie dans le module à semi-conducteur de puissance (100),
- le connecteur de signal électrique interne (12) comprend une structure électriquement isolante commune (4) constituant un support mécaniquement flexible commun pour les conducteurs de signal (12A, 12B) du connecteur de signal électrique interne (12),
- les conducteurs de signal (12A, 12B) comprennent un premier conducteur de signal (12A) et un deuxième conducteur de signal (12B), le premier conducteur de signal (12A) et le deuxième conducteur de signal (12B) étant positionnés sur ou à l'intérieur de la structure électriquement isolante commune (4), et
**caractérisé en ce que** le module à semi-conducteur de puissance (100) comprend une caractéristique additionnelle i ou ii, à savoir
i. la structure électriquement isolante commune (4) constituant le support mécaniquement flexible commun est en plastique ou en caoutchouc, les conducteurs de signal (12A, 12B) étant positionnés à l'intérieur de la structure électriquement isolante commune (4) et étant torsadés ou tressés l'un avec l'autre, les conducteurs de signal (12A, 12B) formant des chemins de signal différents isolés l'un de l'autre, ou
ii. les conducteurs de signal (12A, 12B) forment des chemins de signal différents, la structure électriquement isolante commune (4) constituant le support mécaniquement flexible commun comprenant au moins deux ou plusieurs structures en forme de rainure ou une pluralité d'éléments de fixation, et des conducteurs de signal (12A, 12B) différents étant agencés au moins partiellement dans des structures en forme de rainure différentes ou étant fixés au support mécaniquement flexible commun à des positions prédéterminées par la pluralité d'éléments de fixation.

2. Module à semi-conducteur de puissance (100) selon la revendication 1 comprenant la caractéristique additionnelle ii,
dans lequel une longueur du premier conducteur de signal (12A) est différente d'une longueur du deuxième conducteur de signal (12B).

3. Module à semi-conducteur de puissance (100) selon la revendication 2, dans lequel
le premier conducteur de signal (12A) est positionné de manière flexible par rapport au deuxième conducteur de signal (12B) au moins partiellement à l'intérieur du module à semi-conducteur de puissance (100), et/ou un positionnement du premier conducteur de signal (12A) compris dans le connecteur de signal électrique interne (12) est au moins partiellement fixe par rapport au deuxième conducteur de signal (12B).

4. Module à semi-conducteur de puissance (100) selon l'une quelconque des revendications 1 à 3 comprenant la caractéristique additionnelle ii,
dans lequel la position dans trois dimensions prédéfinie dans le module à semi-conducteur de puissance (100) est prévue de manière à
- réduire une longueur du premier ou du deuxième conducteur de signal (12A, 12B), et/ou
- réduire et/ou ajuster un couplage électrique entre le conducteur de signal (12) et la première partie de module (1, 1A, 1B) et/ou la deuxième partie de module (2, 2A, 2B).

5. Module à semi-conducteur de puissance (100) selon l'une quelconque des revendications 1 à 4 comprenant la caractéristique additionnelle ii,
- le support mécaniquement flexible commun comprend au moins deux ou plusieurs structures en forme de rainure, et
- des conducteurs de signal (12A, 12B) différents sont agencés au moins partiellement dans des structures en forme de rainure différentes.

6. Module à semi-conducteur de puissance (100) selon l'une quelconque des revendications 1 à 4 comprenant la caractéristique additionnelle ii, dans lequel le support mécaniquement flexible commun comprend la pluralité d'éléments de fixation, et
des conducteurs de signal (12A, 12B) différents sont fixés au support mécaniquement flexible commun à des positions prédéterminées par la pluralité d'éléments de fixation.

7. Module à semi-conducteur de puissance (100) selon la revendication 1 comprenant la caractéristique additionnelle i.

8. Procédé de fabrication d'un module à semi-conducteur de puissance (100) comprenant une première partie de module (1, 1A, 1B), une deuxième partie de module (2, 2A, 2B), un connecteur de signal électrique interne (12) et un matériau d'étanchéité (3), comprenant :
la fourniture du module à semi-conducteur de puissance (100) sans le matériau d'étanchéité (3),
le connecteur de signal électrique interne (12) étant mécaniquement flexible et étant électriquement connecté à la première partie de module (1, 1A, 1B) et/ou à la deuxième partie de module (2, 2A, 2B), des conducteurs de signal (12A, 12B) du connecteur de signal électrique interne (12) étant électriquement connectés à la première partie de module (1, 1A, 1B) et/ou à la deuxième partie de module (2, 2A, 2B), et
du fait de sa flexibilité mécanique, le connecteur de signal électrique interne (12) étant configurable dans trois dimensions et étant ajusté à une position dans trois dimensions prédéfinie dans le module à semi-conducteur de puissance (100) ; et
l'application du matériau d'étanchéité (3) sur le connecteur de signal électrique interne (12) de sorte que le connecteur de signal électrique interne (12) soit au moins partiellement encapsulé dans le matériau d'étanchéité (3),
le connecteur de signal électrique interne (12) comprenant une structure électriquement isolante commune (4) constituant un support mécaniquement flexible commun pour les conducteurs de signal (12A, 12B) du connecteur de signal électrique interne (12),
les conducteurs de signal (12A, 12B) comprenant un premier conducteur de signal (12A) et un deuxième conducteur de signal (12B), le premier conducteur de signal (12A) et le deuxième conducteur de signal (12B) étant positionnés sur ou à l'intérieur de la structure électriquement isolante commune (4), et
**caractérisé en ce que** le module à semi-conducteur de puissance (100) comprend une caractéristique additionnelle i ou ii, à savoir
i. la structure électriquement isolante commune (4) est en plastique ou en caoutchouc, les conducteurs de signal (12A, 12B) étant positionnés à l'intérieur de la structure électriquement isolante commune (4) et étant torsadés ou tressés l'un avec l'autre, les conducteurs de signal (12A, 12B) formant des chemins de signal différents isolés l'un de l'autre, ou
ii. les conducteurs de signal (12A, 12B) forment des chemins de signal différents, le support mécaniquement flexible commun comprenant au moins deux ou plusieurs structures en forme de rainure ou une pluralité d'éléments de fixation, et des conducteurs de signal (12A, 12B) différents étant agencés au moins partiellement dans des structures en forme de rainure différentes ou étant fixés au support mécaniquement flexible commun à des positions prédéterminées par la pluralité d'éléments de fixation.

9. Procédé selon la revendication 8,
dans lequel le module à semi-conducteur de puissance (100) comprend la caractéristique additionnelle ii, et
dans lequel une longueur du premier conducteur de signal (12A) est différente d'une longueur du deuxième conducteur de signal (12B).

10. Procédé selon la revendication 9, dans lequel
le premier conducteur de signal (12A) est positionné de manière flexible par rapport au deuxième conducteur de signal (12B) au moins partiellement à l'intérieur du module à semi-conducteur de puissance (100), et/ou
un positionnement du premier conducteur de signal (12A) compris dans le connecteur de signal électrique interne (12) est au moins partiellement fixe par rapport au deuxième conducteur de signal (12B).

11. Procédé selon l'une quelconque des revendications 8 à 10, dans lequel le module à semi-conducteur de puissance (100) comprend la caractéristique additionnelle ii, et dans lequel la position dans trois dimensions prédéfinie dans le module à semi-conducteur de puissance (100) est prévue de manière à
- réduire une longueur du premier ou du deuxième conducteur de signal (12A, 12B), et/ou
- réduire et/ou ajuster un couplage électrique entre le conducteur de signal (12) et la première partie de module (1, 1A, 1B) et/ou la deuxième partie de module (2, 2A, 2B).

12. Procédé selon l'une quelconque des revendications 8 à 11, dans lequel
- le module à semi-conducteur de puissance (100) comprend la caractéristique additionnelle ii,
- le support mécaniquement flexible commun comprend au moins deux ou plusieurs structures en forme de rainure, et
- des conducteurs de signal (12A, 12B) différents sont agencés au moins partiellement dans des structures en forme de rainure différentes.

13. Procédé selon l'une quelconque des revendications 8 à 11, dans lequel
- le module à semi-conducteur de puissance (100) comprend la caractéristique additionnelle ii,
- le support mécaniquement flexible commun comprend une pluralité d'éléments de fixation, et
- des conducteurs de signal (12A, 12B) différents sont fixés au support mécaniquement flexible commun à des positions prédéterminées par la pluralité d'éléments de fixation.

14. Procédé selon la revendication 8, dans lequel le module à semi-conducteur de puissance (100) comprend la caractéristique additionnelle i.
